Europäisches Patentamt

(19) European Patent Office

Office européen des brevets

(11) Numéro de publication : **0 289 409 B1**

(12) **FASCICULE DE BREVET EUROPEEN**

(45) Date de publication du fascicule du brevet :
27.11.91 Bulletin 91/48

(51) Int. Cl.⁵ : **H05K 13/02, H01L 21/00**

(21) Numéro de dépôt : **88400995.2**

(22) Date de dépôt : **22.04.88**

(54) **Dispositif de distribution d'éléments en nombre sur des plaques.**

(30) Priorité : **29.04.87 FR 8706105**

(43) Date de publication de la demande :
**02.11.88 Bulletin 88/44**

(45) Mention de la délivrance du brevet :
**27.11.91 Bulletin 91/48**

(84) Etats contractants désignés :
**DE GB IT**

(56) Documents cités :
**US-A- 4 393 808
US-A- 4 395 184**

(73) Titulaire : **COMPAGNIE EUROPEENNE DE
COMPOSANTS ELECTRONIQUES LCC
50, rue Jean-Pierre Timbaud
F-92400 Courbevoie (FR)**

(72) Inventeur : **Reamot, Hervé
THOMSON-CSF SCPI 19, avenue de Messine
F-75008 Paris (FR)**
Inventeur : **Bredillet, Claude
THOMSON-CSF SCPI 19, avenue de Messine
F-75008 Paris (FR)**
Inventeur : **Brisville, Pierre
THOMSON-CSF SCPI 19, avenue de Messine
F-75008 Paris (FR)**

(74) Mandataire : **Guérin, Michel et al
THOMSON-CSF SCPI
F-92045 PARIS LA DEFENSE CEDEX 67 (FR)**

**Description**

La présente invention concerne un dispositif de distribution d'éléments en nombre sur des plaques. Elle permet en particulier la distribution de condensateurs chips sur des plaques à alvéoles.

On connaît différents dispositifs qui permettent la distribution ou le rangement d'éléments en nombre dans des boîtes ou sur des plaques à alvéoles. Ces dispositifs mettent en oeuvre des systèmes vibreurs ou vibrateurs. Les vibreurs utilisent l'effet électromagnétique et ne permettent pas aux éléments à distribuer de s'entrechoquer. Ils sont bien adaptés à l'acheminement des éléments jusqu'à un endroit déterminé mais pas à leur rangement. Les vibrateurs par contre, qui utilisent l'effet mécanique, permettent aux éléments de s'entrechoquer ce qui facilite leur rangement ou leur distribution. Du fascule de brevet US-A-4,393,808 est connu un dispositif selon le préambule de la revendication 1. Dans le cas du rangement de condensateurs chips sur des plaques à alvéoles, on connaît une machine qui traite les chips depuis leur arrivée en vrac jusqu'aux opérations de contrôle électrique, d'argenture, d'étamage, de marquage. Cette machine utilise un vibrateur et nécessite un opérateur en permanence qui doit s'assurer que les paramètres de consigne soient respectés. L'expérience a démontré qu'au délà de 4 paramètres de consigne, l'opérateur rencontrait de grandes difficultés à maîtriser les temporisations et les réglages de vitesse des moteurs de vibrateurs. Les interférences entre paramètres et leur estimation empirique ne facilitent pas leur mise en oeuvre. Ces problèmes font que le rendement de l'opération de distribution n'est pas satisfaisant.

Pour pallier ces inconvénients, l'invention propose un système à apprentissage où toute latitude est laissée à la discrétion de l'opérateur sans aucune contrainte de réflexion ou d'interprétation. L'opérateur peut effectuer le remplissage d'une plaque grâce à un manipulateur à plusieurs directions pour les débattements latéraux et frontaux et grâce à un variateur de vitesse pour commander la vitesse du moteur du vibrateur. Dans ce cas deux actionneurs seulement sont donc à la disposition de l'opérateur. Le système d'apprentissage prend en compte ces différentes actions à des instants déterminés pendant la durée estimée nécessaire au déroulement de l'opération de distribution. Le remplissage terminé, l'opérateur demande une marche automatique pour la deuxième opération. Si l'essai est concluant, le programme peut être mis en mémoire. On peut ainsi stocker plusieurs programmes. Il est donc possible d'aller chercher un programme expérimenté pour un type de pièce spécifié sans perte de temps.

L'invention a donc pour objet un dispositif de distribution d'éléments en nombre sur une plaque de rangement logée dans un réceptacle contenant lesdits éléments, la distribution des éléments se faisant par une action mécanique imprimée au réceptacle pendant une durée déterminée, caractérisé en ce que le dispositif comprend des moyens permettant son fonctionnement en apprentissage par enregistrement des paramètres de l'action mécanique et leur mise en mémoire, ces moyens permettant la marche automatique du dispositif en fonction des paramètres enregistrés.

L'invention sera mieux comprise et d'autres avantages apparaîtront grâce à la description qui va suivre, donnée à titre non limitatif, et grâce aux dessins annexés parmi lesquels :
— la figure 1 représente schématiquement un dispositif de distribution d'éléments selon l'art connu,
— la figure 2 représente des diagrammes explicatifs du fonctionnement du dispositif de la figure 1,
— les figures 3, 4 et 5 sont des organigrammes mis en oeuvre dans le dispositif selon l'invention,
— la figure 6 est un synoptique illustrant un dispositif selon l'invention.

La partie de la description qui va suivre portera surtout sur la distribution de condensateurs chips sur des plaques à alvéoles mais il est entendu que l'invention peut s'appliquer à tout autre élément et que les logements que possèdent les plaques peuvent être de géométrie différente.

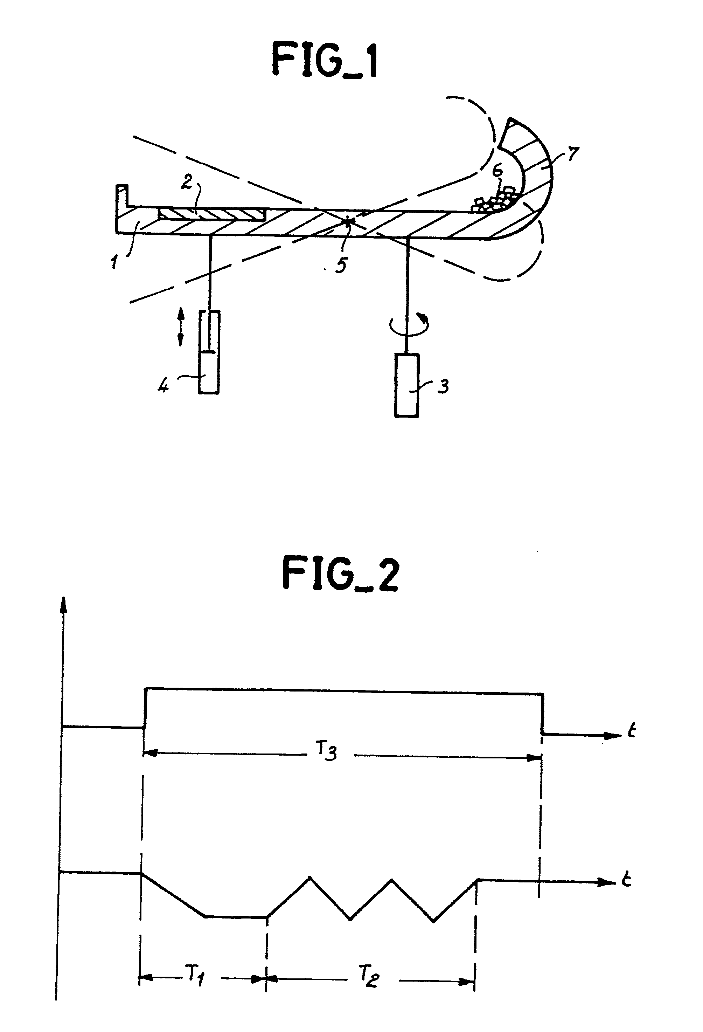

Le dispositif de l'art connu représenté à la figure 1 comprend un réceptacle 1 dans lequel est disposée une plaque à alvéoles 2. Le réceptacle 1 peut être animé d'un mouvement complexe provoqué par le moteur 3 et le vérin 4. Le moteur 3 est un moteur à vitesse variable lié à un excentrique. Il donne un mouvement curviligne vibratoire d'amplitude et de fréquence réglables. Le vérin 4 permet le basculement du réceptacle 1 autour de l'axe 5. Il permet au réceptacle de prendre les positions extrêmes représentées en traits interrompus. Le fonctionnement du dispositif est le suivant. Les condensateurs chips à distribuer, représentés sous la référence générale 6, sont d'abord accumulés en vrac dans le coude 7 du réceptacle situé à l'opposé de la plaque 2. Par action du vérin 4 et du moteur 3, les condensateurs chips sont amenés sur la plaque 2 et se logent plus ou moins rapidement dans les alvéoles de la plaque. Plusieurs basculements de la plaque, par action du vérin, sont nécessaires. Lorsqu'un nombre suffisant de condensateurs ont été distribués, un dernier basculement du réceptacle fait revenir les condensateurs en excédent vers le coude 7 et la plaque est enlevée.

L'efficacité de la distribution des chips est tributaire du taux de remplissage de la plaque et du temps consacré à cette opération. Il est donc important que l'opérateur maîtrise bien plusieurs paramètres constitués par le temps de montée et de descente du vérin et leur nombre, la vitesse du moteur, la durée totale de l'opération, la combinaison des actions du vérin et du moteur.

Les diagrammes de la figure 2 illustrent un exemple de cycle de fonctionnement imposé au dispositif de la figure 1, en fonction du temps t. Dans le diagramme du haut, $T_3$ représente la durée totale du cycle. Le diagramme du bas représente les mouvements du vérin 4 : descente, montée et état horizontal. Le vérin étant initialement en position haute, les condensateurs chips sont livrés dans le coude 7 du réceptacle 1. La première partie de $T_1$ (descente du vérin) consiste à amener les condensateurs du coude sur la plaque. Le vérin étant en position basse, le moteur est mis en route et les condensateurs se distribuent dans les alvéoles de la plaque. $T_2$ représente le temps pendant lequel les condensateurs sont balayés sur la plaque. Ce balayage est provoqué par des montées et des descentes successives du vérin et par le mouvement imprimé au réceptacle par le moteur 3. A la fin du cycle, le vérin est à nouveau en position haute pour évacuer vers le coude 7 les condensateurs qui n'ont pas trouvé place dans les alvéoles.

La maîtrise de ces différents paramètres n'est pas une chose facile pour l'opérateur. En outre, la géométrie et le poids des condensateurs peuvent être différents d'une série à une autre et la distribution s'en ressent. Tout ceci conduit à un taux de remplissage insatisfaisant pour une durée de l'opération déterminée. L'invention permet d'améliorer le rendement de l'opération par une méthode d'apprentissage. Grâce à cette méthode, il est possible d'animer le réceptacle d'un troisième mouvement qui contribuera à augmenter le taux de remplissage de la plaque. Ce troisième mouvement peut par exemple être un basculement latéral du réceptacle.

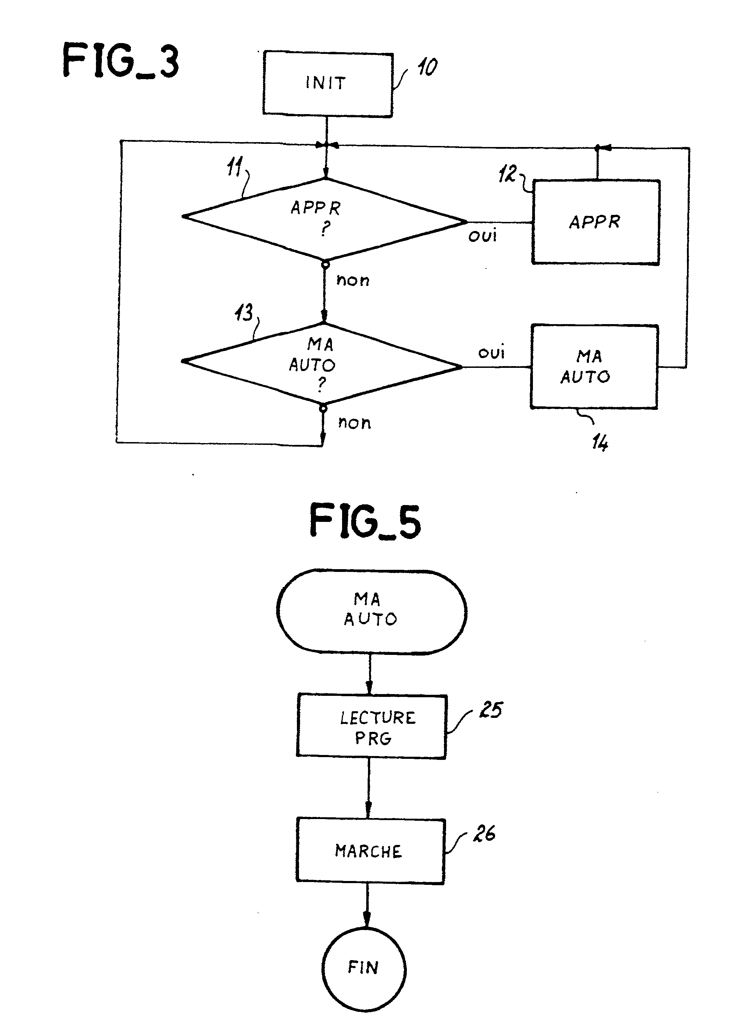

L'apprentissage va permettre au dispositif d'améliorer son fonctionnement par la prise en compte des résultats passés. Cet apprentissage peut être mis en oeuvre selon les organigrammes représentés aux figures 3 à 5. La figure 3 représente un organigramme simplifié de l'apprentissage. Le bloc 10 représente la mise sous tension ou initialisation (INIT). Le bloc 11 est un test : si on veut procéder à un apprentissage (APPR) on passe au bloc 12, sinon on passe au bloc 13. Dans le cas où l'apprentissage a été demandé, une fois celui-ci exécuté on revient au bloc 11. Dans le cas où l'apprentissage a été refusé, on passe au bloc 13 qui est un test de marche automatique (MA AUTO). Si la marche automatique a été demandée on passe au bloc 14 et après son déroulement on revient au bloc 11. Si la marche automatique a été refusée on revient au bloc 11.

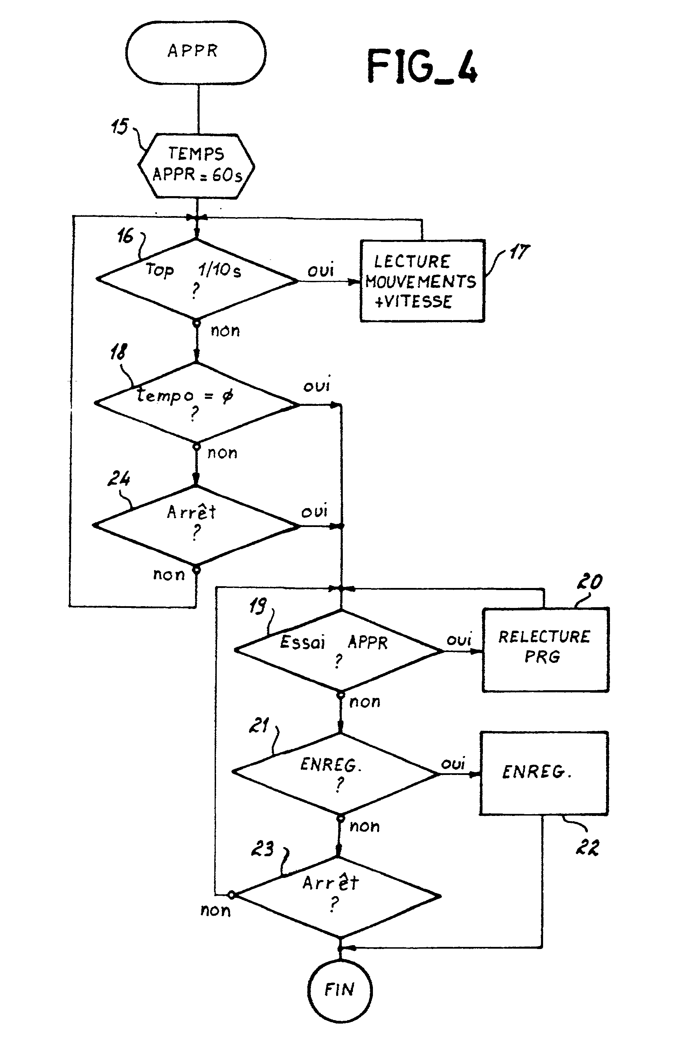

La figure 4 est un organigramme développé de l'étape d'apprentissage figurée par le bloc 12 dans la figure 3. Le bloc 15 fixe la durée maximale de l'apprentissage qui est par exemple de 60 secondes. Le bloc 16 est un test qui demande s'il faut ou non faire certaines mesures à des intervalles (TOP) déterminés, par exemple tous les dixièmes de seconde. Si la réponse est oui, on passe au bloc 17 qui représente la lecture de certains paramètres déterminants de la distribution (mouvements, vitesse) et leur écriture dans une mémoire, et on revient au test 16 pour recommencer un cycle de lecture autant de fois que la durée de l'apprentissage n'est pas terminée. Si la réponse au test 16 est négative, on passe au test 18 qui détermine si la durée de la temporisation (tempo) est achevée ou non. Si la réponse est positive, on passe au test 19 qui demande si on veut faire un essai de l'apprentissage effectué précédemment. Si oui, on passe au bloc 20, c'est-à-dire que l'on relit le programme (PRG) enregistré précédemment dans la mémoire et on revient au test 19. Si la réponse au test 19 est négative, on passe au test 21 qui demande s'il faut enregistrer (ENREG) ce programme pour le sauvegarder. Si oui, on passe au bloc 22 pour exécution et l'opération d'apprentissage est terminée. Sinon, on passe au test 23 pour arrêter ou reprendre l'essai d'apprentissage. Si la réponse au test 18 est négative, on passe au test 24 qui demande s'il faut arrêter l'apprentissage. Si la réponse est positive (par exemple dans le cas où l'apprentissage est considéré terminé avant le temps limite imposé) on passe au test 19 et au cycle qui a déjà été décrit. Si la réponse est négative, on revient au niveau du test 16.

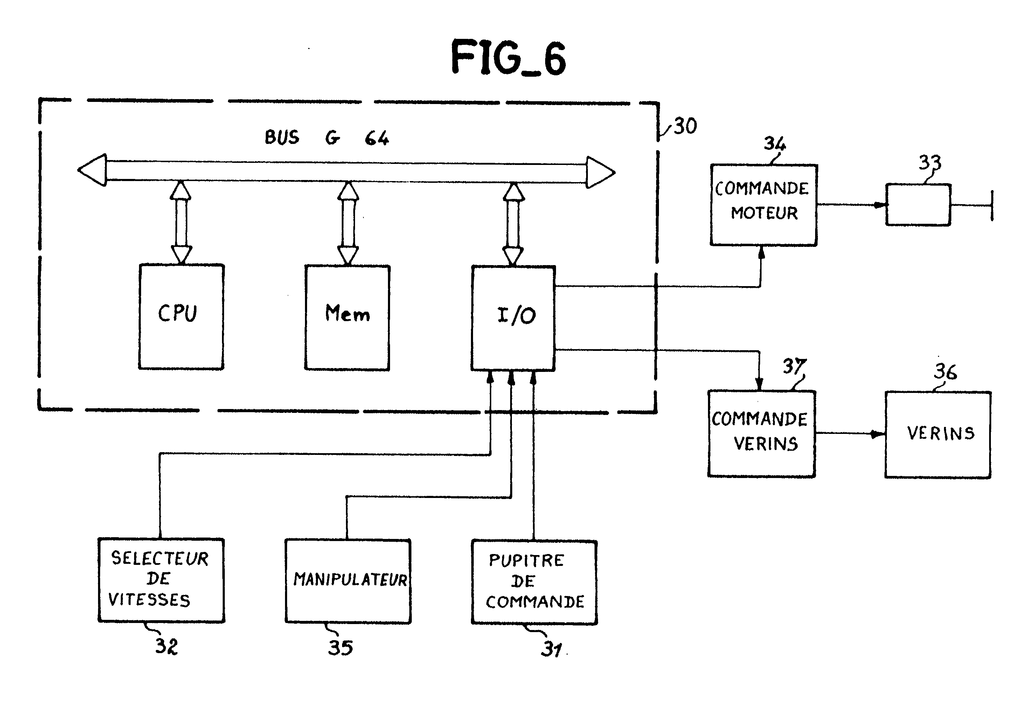

La figure 5 est un organigramme développé de l'étape de marche automatique figurée par le bloc 14 dans la figure 3. Lorsque la marche automatique est demandée, le bloc 25 déclenche la lecture du programme désiré dont les instructions sont envoyées au bloc 26 qui détermine le fonctionnement du réceptacle.

Les moyens mis en oeuvre pour animer mécaniquement le réceptacle supportant la plaque à alvéole peuvent être : un moteur à vitesse variable lié à un excentrique et qui imprime un mouvement curviligne vibratoire d'amplitude et de fréquence réglable, un vérin trois positions pour fournir une oscillation latérale, un vérin classique à deux positions pour permettre un basculement frontal de l'ensemble. L'ajout d'autres mouvements serait théoriquement possible mais cela outrepasserait les capacités de l'opérateur. Ces mouvements sont variables en vitesse et en durée. La rotation du moteur doit pouvoir varier pendant le cycle. Une fréquence élevée des vibrations engendrées provoque une arrivée rapide des pièces au droit des alvéoles et une fréquence plus faible et modulée, un rangement optimal. En fin de cycle, une forte vibration est nécessaire pour que le surplus de pièces dégage rapidement la plaque. La vitesse des vérins par contre est figée par les limiteurs de débit.

Chaque type de pièces à ranger nécessite des paramètres de cycle différents qui dépendent de la géométrie et du poids des pièces. Dans le cas de condensateurs chips, la géométrie et le poids peuvent varier dans un rapport de un à six suivant les modèles. *Un opérateur expérimenté peut, avec le dispositif selon l'invention, remplir une plaque de 800 alvéoles (40 colonnes de 20 rangées) à 99% en 60 s maximum.*

L'opérateur peut effectuer le remplissage d'une plaque avec un manipulateur à plusieurs directions pour les débattements latéraux et frontaux. Un commutateur à 5 positions peut commander la vitesse du moteur par un jeu de résistances. Des actionneurs seulement (levier du manipulateur et commutateur) sont donc à la disposition de l'opérateur. Le système d'apprentissage prend en compte ses différentes actions tous les dixièmes de seconde pendant une durée maximum de une minute. Des capteurs de position et de vitesse de types connus permettent de prélever ces informations. Le remplissage terminé, l'opérateur demande une marche automatique pour une deuxième opération. Si l'essai est concluant, le programme peut être mis en mémoire. On peut utiliser une roue codeuse pour donner un repère à ce programme qui est emmagasiné parmi d'autres (par exemple 10 programmes). Il est donc possible d'aller chercher un programme expérimenté pour un type de pièces spécifié sans perte de temps. Le matériel utilisé peut être composé de sous-ensembles standards, compatibles BUS G64. On peut employer le microprocesseur Motorola 6809. Un rack 19 pouces 3U contient l'ensemble de l'asservissement qui est composé d'une carte unité centrale, d'une carte mémoire RAM de 8 k O sauvegardées et de 4 k O REPROM programme et d'une carte entrées/sorties. La figure 6 est un synoptique illustrant un dispositif selon l'invention et utilisant un microprocesseur 30 du type décrit ci-dessus. On a représenté respectivement sous les références CPU, Mem et I/O les cartes unité centrale, mémoire et entrées/sorties. Un pupitre de commande 31 permet la mise en route et l'arrêt du dispositif et d'effectuer les différentes opérations indiquées plus haut (fixation de la durée de l'apprentissage, de la durée des intervalles de mesures, etc.). Pour l'exemple choisi, un sélecteur de vitesses 32 permet de faire varier la vitesse du moteur 33 par l'intermédiaire d'un circuit de commande moteur 34 et un manipulateur 35 permet de commander les vérins 36 par l'intermédiaire d'un circuit de commande vérins 37. La carte entrées/sorties I/O assure l'interface entre les organes de commande 31, 32 et 35, les systèmes électromécaniques 34 et 37 et les cartes Mem et CPU.

## Revendications

1. Dispositif de distribution d'éléments en nombre sur une plaque de rangement (2) logée dans un réceptacle (1) contenant lesdits éléments (6), la distribution des éléments se faisant par une action mécanique imprimée au réceptacle (1) pendant une durée déterminée, caractérisé en ce que le dispositif comprend des moyens (10 à 14) permettant son fonctionnement en apprentissage par enregistrement des paramètres de l'action mécanique et leur mise en mémoire, ces moyens permettant la marche automatique du dispositif en fonction des paramètres enregistrés.

2. Dispositif selon la revendication 1, caractérisé en ce que l'action mécanique imprimée au réceptacle (1) est produite par au moins un moteur (3).

3. Dispositif selon la revendication 2, caractérisé en ce que ledit moteur (3) est lié à un excentrique pour donner un mouvement curviligne vibratoire.

4. Dispositif selon l'une des revendications 2 ou 3, caractérisé en ce que ledit moteur (3) est à vitesse variable.

5. Dispositif selon l'une quelconque des revendications 1 à 4, caractérisé en ce que l'action mécanique imprimée au réceptacle (1) est produite par au moins un vérin (4).

6. Dispositif selon l'une quelconque des revendications 1 à 5, caractérisé en ce que la plaque de rangement (2) est une plaque à alvéoles.

7. Dispositif selon l'une quelconque des revendications 1 à 6, caractérisé en ce que lesdits éléments (6) sont des condensateurs sous forme de chips.

## Patentansprüche

1. Vorrichtung zum Verteilen zahlreicher Elemente in einer Sortierplatte (2), die sich in einem die Elemente (6) enthaltenden Auffang (1) befindet, wobei die Verteilung der Elemente durch eine mechanische Betätigung geschieht, die auf den Auffang (1) während einer bestimmten Zeitdauer ausgeübt wird, dadurch gekennzeichnet, daß die Vorrichtung Mittel (10-14) umfaßt, die durch die Aufzeichnung von Parametern der mechanischen Betätigung und durch deren Speicherung einen lernenden Betrieb der Vorrichtung ermöglichen und die den automatischen Betrieb der Vorrichtung in Abhängigkeit von den aufgezeichneten Parametern ermöglichen.

2. Vorrichtung gemäß Anspruch 1, dadurch gekennzeichnet, daß die auf den Auffang (1) ausgeübte mechanische Betätigung von wenigstens einem Motor (3) erzeugt wird.

3. Vorrichtung gemäß Anspruch 2, dadurch gekennzeichnet, daß der Motor (3) mit einem Exzenter verbunden ist, um eine gekrümmte vibrierende Bewegung auszugeben.

4. Vorrichtung gemäß einem der Ansprüche 2 oder 3, dadurch gekennzeichnet, daß der Motor (3) mit veränderbarer Geschwindigkeit läuft.

5. Vorrichtung gemäß einem der Ansprüche 1 bis 4, dadurch gekennzeichnet, daß die auf den Auffang (1) ausgeübte mechanische Betätigung von wenigstens einem Arbeitszylinder erzeugt wird.

6. Vorrichtung gemäß einem der Ansprüche 1 bis 5, dadurch gekennzeichnet, daß die Sortierplatte (2) eine Platte mit zellenartigen Vertiefungen ist.

7. Vorrichtung gemäß einem der Ansprüche 1 bis 6, dadurch gegekennzeichnet, daß die Elemente (6) Kondensatoren in Gestalt von Chips sind.

## Claims

1. A device for the distribution of a plurality of elements on an arrangement plate (2) positioned in a receptacle (1) containing the said elements (6), the distribution of the elements being performed by a mechanical action imparted on the receptacle (1) during a predetermined time, characterized in that the device comprises means (10 through 14) making possible the function thereof in a learning time with the registration of the parameters of the mechanical action and the storing thereof, said means making possible the automatic operation of the device in accordance with the registered parameters.

2. The device as claimed in claim 1, characterized in that the mechanical action imparted to the receptacle (1) is produced by at least one motor (3).

3. The device as claimed in claim 2, characterized in that the said motor (3) is connected with an eccentric in order to provide a vibratory movement along a curved path.

4. The device as claimed in claim 1 or in claim 3, characterized in that the said motor (3) is a variable speed motor.

5. The device as claimed in any one of the preceding claims 1 through 4, characterized in that the mechanical action imparted to the receptacle (1) is produced by at least one fluid power cylinder (4).

6. The device as claimed in any one of the preceding claims 1 through 5, characterized in that the arrangement plate (2) is a plate with sockets therein.

7. The device as claimed in any one of the preceding claims 1 through 6, characterized in that the said elements (6) are capacitors in the form of chips.

# FIG_1

# FIG_2

# FIG_3

INIT 10

11 APPR ?

oui → APPR 12

non

13 MA AUTO ?

oui → MA AUTO 14

non

# FIG_5

MA AUTO

LECTURE PRG 25

MARCHE 26

FIN

# FIG_4

APPR

*15* TEMPS APPR = 60s

*16* Top 1/10s ? —oui→ LECTURE MOUVEMENTS +VITESSE *17*

non

*18* tempo = ∅ ? —oui→

non

*24* Arrêt ? —oui→

non

*19* Essai APPR ? —oui→ RELECTURE PRG *20*

non

*21* ENREG. ? —oui→ ENREG. *22*

non

*23* Arrêt ?

non

FIN

# FIG_6

SELECTEUR
DE
VITESSES

MANIPULATEUR

PUPITRE
DE
COMMANDE

COMMANDE
MOTEUR

COMMANDE
VERINS

VERINS

BUS   G   64

CPU

Mem

I/O

EP 0 289 409 B1